Europäisches Patentamt

European Patent Office

Office européen des brevets

(11) Veröffentlichungsnummer: **0 087 079**
**A2**

(12) **EUROPÄISCHE PATENTANMELDUNG**

(21) Anmeldenummer: 83101294.3

(22) Anmeldetag: 10.02.83

(51) Int. Cl.³: **H 03 H 9/02**
**H 03 H 9/36**

(30) Priorität: 23.02.82 DE 3206401

(43) Veröffentlichungstag der Anmeldung:
31.08.83 Patentblatt 83/35

(84) Benannte Vertragsstaaten:
AT BE DE FR GB IT LU NL

(71) Anmelder: SIEMENS AKTIENGESELLSCHAFT
Berlin und München Wittelsbacherplatz 2
D-8000 München 2(DE)

(72) Erfinder: Diepers, Heinrich, Dr.
Veit-Stoss-Strasse 44
D-8552 Höchstadt(DE)

(72) Erfinder: Sachs, Bertram
Dorfstrasse 30
D-8520 Erlangen-Büchenbach(DE)

(54) Ultraschall-Verzögerungsleitung.

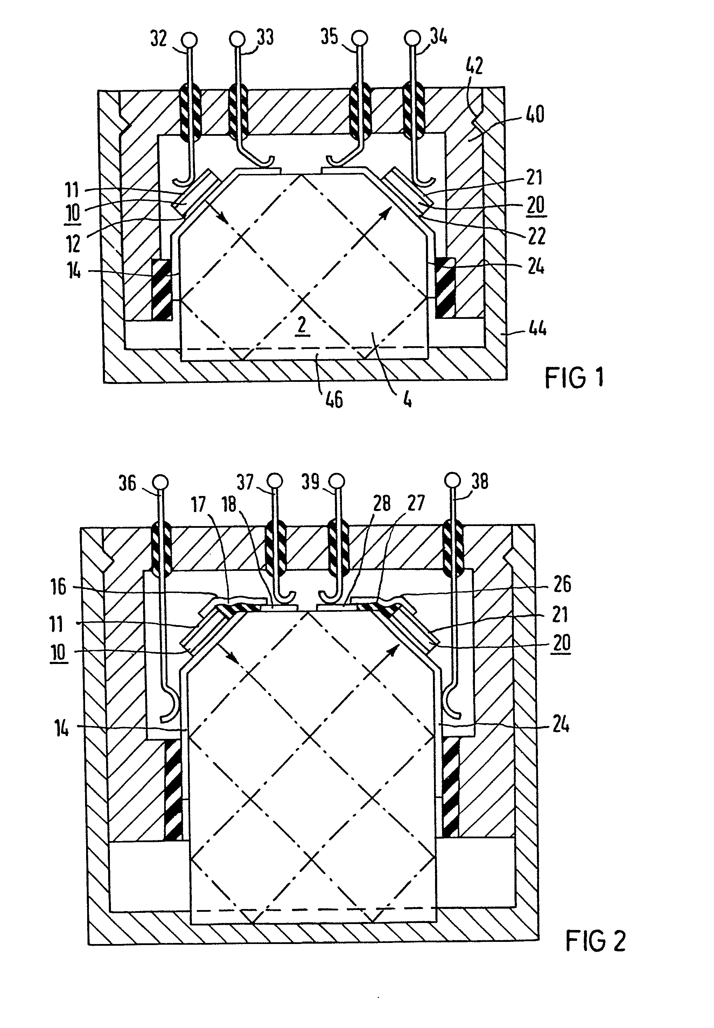

(57) Die Ultraschall-Verzögerungsleitung enthält Ultraschall-Scherschwinger (10, 20), die auf den Schmalseiten eines flachen Profilkörpers (4) angeordnet und deren Elektroden (11, 12; 21, 22) jeweils mit einem Anschlußleiter elektrisch leitend verbunden sind. Die Erfindung besteht darin, daß zur unmittelbaren oder mittelbaren elektrischen Kontaktierung Federkontakte (32 bis 35) vorgesehen sind. Diese Federkontakte (32 bis 35) bilden jeweils einen Druckkontakt entweder unmittelbar mit einer der Elektroden (11, 12) oder mit einer Metallauflage (14, 24) des Verzögerungsmediums (4), die mit einer der Elektroden (12, 22) elektrisch leitend verbunden ist. Zur Kontaktierung wird die Ultraschall-Verzögerungsleitung lediglich in eine Klemmhalterung (40) eingesetzt, durch welche die Federkontakte (32 bis 35) elektrisch isoliert hindurchgeführt sind (Fig. 1).

FIG 1

EP 0 087 079 A2

0087079

SIEMENS AKTIENGESELLSCHAFT                Unser Zeichen
Berlin und München                       VPA 82 P 3 0 4 7 E

Ultraschall-Verzögerungsleitung

Die Erfindung bezieht sich auf eine Ultraschall-Verzögerungsleitung, insbesondere für Farbfernsehempfänger, mit piezoelektrischen Ultraschall-Scherwandlern, die auf den Schmalseiten eines flachen Profilkörpers aus einem Verzögerungsmedium angeordnet und deren Elektroden jeweils mit einem Anschlußleiter elektrisch leitend verbunden sind.

Auf der Ultraschalltechnik aufbauende Verzögerungsleitungen bestehen bekanntlich im wesentlichen aus einem piezoelektrischen Ultraschall-Scherwandler als Eingangswandler, der quer zur Richtung der anliegenden Signalspannung polarisiert ist, sowie einem Verzögerungsmedium und einem Ausgangswandler. Der Eingangswandler setzt ein zugeführtes elektrisches Signal in entsprechende mechanische Schwingungen um, die das Verzögerungsmedium, beispielsweise Glas, durchlaufen und in diesem Medium eine geringe Schallgeschwindigkeit erhalten. Sie werden im Ausgangswandler wieder in elektrische Schwingungen zurücktransformiert. Durch die Gestaltung des Verzögerungsmediums als flacher Profilkörper, der zur Abdämpfung von Seitenkeulen auf seinen Flachseiten noch mit sogenannten Dämpferpunkten versehen sein kann, wird die Schallwelle mehrfach reflektiert und damit die Gesamtlänge der Leitung wesentlich vermindert. Die Ausdehnung des Profilkörpers wird vorzugsweise kleiner gewählt als die halbe Wellenlänge der Ultraschallschwingung. Mit solchen Verzögerungsleitungen erhält man eine große Stör-

Kin 2 Koe / 15.2.1982

signaldämpfung und zugleich nur eine geringe Betriebsdämpfung ("Funkschau" 1973, Heft 6, Seiten 1005 bis
1008).

Etwa die gleiche geringe Ausdehnung in Richtung der
Dicke des Profilkörpers haben auch die Ultraschall-
Scherwandler, deren Elektroden jeweils mit einem elektrischen Anschlußleiter kontaktiert werden müssen. Da
die Ultraschall-Verzögerungsleitung ein Präzisionsbauteil ist, das hohe geometrische Maßgenauigkeit erfordert und hohe Ansprüche an die Verarbeitungstechnologie
stellt, können die üblichen Lotverbindungen nur mit
einem verhältnismäßig großen Aufwand hergestellt
werden.

Der Erfindung liegt deshalb die Aufgabe zugrunde, eine
Ultraschall-Verzögerungsleitung anzugeben, die verhältnismäßig einfach hergestellt werden kann und bei
der die Signalleitungen wesentlich einfacher elektrisch kontaktiert werden können.

Diese Aufgabe wird erfindungsgemäß gelöst mit dem
kennzeichnenden Merkmal des Anspruchs 1. Die Federkontakte bilden jeweils einen Druckkontakt entweder
direkt mit einer der Elektroden der Ultraschall-Scherwandler oder mit einer Metallauflage des Profilkörpers
aus dem Verzögerungsmedium, die mit einer der Elektroden elektrisch leitend verbunden ist. Die Federkontakte
können durch eine Rahmenhalterung elektrisch gegeneinander isoliert hindurchgeführt werden, die vorzugsweise als Klemmhalterung ausgeführt sein kann. Der
scheibenförmige Profilkörper mit seinen Ultraschall-
Scherwandlern kann in diese Halterung einfach eingeschoben werden, beispielsweise gegen einen Anschlag,
und erhält damit eine mechanische Fixierung bei gleichzeitig hergestellten elektrischen Kontakten.

Zur weiteren Erläuterung der Erfindung wird auf die Zeichnung Bezug genommen, in deren Figuren 1 und 2 jeweils eine Ausführungsform einer Ultraschall-Verzögerungsleitung nach der Erfindung als Schnitt schematisch veranschaulicht sind.

In der Ausführungsform einer in Figur 1 dargestellten Ultraschall-Verzögerungsleitung 2, die beispielsweise für Farbfernsehempfänger nach dem PAL-System oder auch nach dem SECAM-System vorgesehen sein kann, ist ein scheibenförmiger Profilkörper 4 in den Oberflächenbereichen seiner Schmalseiten, die zur Befestigung von Ultraschall-Scherwandlern 10 bzw. 20 vorgesehen sind, jeweils mit einer Metallisierung 14 bzw. 24 versehen, die vorzugsweise jeweils aus mehreren in der Figur zur Vereinfachung nicht dargestellten Schichten verschiedener Metallkomponenten bestehen können. Der Profilkörper 4 besteht aus einem festen Verzögerungsmedium, vorzugsweise Glas. Die beiden Flachseiten der Ultraschall-Scherwandler 10 und 20 sind jeweils mit Elektroden 11 und 12 bzw. 21 und 22 versehen, die aus einer Metallisierung bestehen. Die zur Befestigung an den Metallisierungen 14 und 24 vorgesehenen Elektroden 12 bzw. 22 können vorzugsweise ebenfalls jeweils aus Schichten verschiedener Metallkomponenten bestehen, die in der Figur nicht dargestellt sind.

Zur Kontaktierung der Elektroden 11 und 12 bzw. 21 und 22 sind Federkontakte vorgesehen, die in der Figur mit 32 bis 35 bezeichnet sind und deren federnde Enden jeweils einen Druckkontakt bilden. Der Federkontakt 32 stellt durch seinen Druckkontakt eine unmittelbare elektrische Verbindung zwischen der Elektrode 11 des Ultraschall-Scherwandlers 10 und einem in der Figur nicht dargestellten äußeren elektrischen Anschlußleiter her. Sein Ende ist deshalb für eine Lotverbindung geeignet, was in der Figur durch eine Verbreiterung angedeutet ist. In gleicher Weise ist der Federkontakt 34 mit der Elektrode 21 des Ultraschall-
Scherwandlers 20 verbunden. Die Federkontakte 33 und
35 stellen durch ihren Druckkontakt mit einer der
Metallauflagen 14 und 24 jeweils mittelbar eine elektrische Leitungsverbindung zwischen der Elektrode 12
bzw. 22 und einem elektrischen Anschlußleiter her.

Die Federkontakte 32 bis 35 sind durch eine Rahmenhalterung 40 mechanisch fixiert und elektrisch isoliert
hindurchgeführt, die vorzugsweise als Klemmhalterung
ausgeführt sein und vorzugsweise aus elektrisch isolierendem Material, insbesondere Kunststoff, bestehen kann.
Sie ist an ihrer äußeren Mantelfläche in der Nähe des
Randes mit einer Kerbe 42 versehen, die zur Fixierung
einer topfförmigen Schutzkappe 44 dient. Die Ultraschall-Verzögerungsleitung 2 wird mit Hilfe der Schutzkappe 44, deren Boden vorzugsweise noch mit einer
Nut 46 zum Einsetzen des Profilkörpers 4 versehen sein
kann, in die Rahmenhalterung 40 eingeschoben, bis eine
beispielsweise an ihrer inneren Mantelfläche in der
Nähe des Randes angeordnete Noppe in die Nut 42 der
Rahmenhalterung 40 einrastet. Damit ist die Ultraschall-Verzögerungsleitung 2 innerhalb der Rahmenhalterung 40 mechanisch fixiert und die elektrische
Kontaktierung der Ultraschall-Scherschwinger 10 und 20
hergestellt. Da im allgemeinen dieser Vorgang nur
einmal stattfindet, sind an die Ausführungsform der
Federkontakte 32 bis 35 keine hohen Ansprüche zu
stellen.

In der abweichenden Ausführungsform einer Ultraschall-Verzögerungsleitung 2 nach Figur 2 sind auch die vom Profilkörper 4 abgewandten Elektroden 11 und 21 der Ultraschall-Scherwandler 10 bzw. 20 jeweils mit Hilfe einer Kontaktbrücke 16 bzw. 26 jeweils mit einer Metallauflage 18 bzw. 28 des Profilkörpers 4 verbunden. In dieser Ausführungsform wird die elektrische Kontaktierung der Elektroden der Ultraschall-Scherwandler 10 und 20 mit Hilfe von Federkontakten hergestellt, die jeweils einen Druckkontakt mit einer der Metallauflagen 14 und 18 sowie 24 und 28 bilden und die in der Figur mit 36 bis 39 bezeichnet sind.

In einer weiteren Ausführungsform der Ultraschall-Verzögerungsleitung 2 ist der zwischen den Metallauflagen 14 und 18 sowie 24 und 28 teilweise metallfreie oder vom Metall befreite Oberflächenbereich der Schmalfläche des Profilkörpers 4 einschließlich jeweils einer der Stirnseiten der Ultraschall-Scherschwinger 10 und 20 mit einer elektrisch isolierenden Abdeckung 17 bzw. 27 versehen, die beispielsweise aus Siliziumdioxid $SiO_2$ oder auch aus Aluminiumoxid $Al_2O_3$ bestehen kann. Auf diese Abdeckungen 17 und 27 können vorteilhaft die Kontaktbrücken 16 bzw. 26 aufgebracht, vorzugsweise aufgesputtert oder auch aufgedampft, werden.

Im Ausführungsbeispiel wurde die Kontaktierung durch Federkontakte veranschaulicht, die jeweils einen Druckkontakt entweder unmittelbar mit einer der Elektroden oder mittelbar über eine mit einer Elektrode verbundene Metallauflage herstellen. Weitere Ausführungsformen in bezug auf die Anordnung der Federkontakte 32 bis 39 sowie der Ausführung und Anordnung der Rahmenhalterung 40 im Verhältnis zum Profilkörper 4 und in bezug

**0087079**

auf geometrisch anders gestaltete Verzögerungsleitungen 2 können ohne weitere Überlegungen abgeleitet
werden.

2 Patentansprüche
2 Figuren

<u>Patentansprüche</u>

1. Ultraschall-Verzögerungsleitung (2), insbesondere für Farbfernsehempfänger, mit piezoelektrischen Ultraschall-Scherwandlern (10, 20), die auf den Schmalseiten eines flachen Profilkörpers (4) aus einem Verzögerungsmedium angeordnet sind und deren Elektroden (11, 12 bzw. 21, 22) jeweils mit einem Anschlußleiter elektrisch leitend verbunden sind, d a d u r c h  g e - k e n n z e i c h n e t ,  daß zur unmittelbaren oder mittelbaren elektrischen Kontaktierung der Elektroden (11, 12; 21, 22) Federkontakte (32 bis 39) vorgesehen sind.

2. Ultraschall-Verzögerungsleitung nach Anspruch 1, d a d u r c h  g e k e n n z e i c h n e t ,  daß wenigstens ein Teil der Federkontakte (33, 35 sowie 36 bis 39) jeweils einen Druckkontakt mit einer Metallauflage (14, 24; 18, 28) bilden, die jeweils mit einer der Elektroden (12, 22; 11, 21) elektrisch leitend verbunden sind.

FIG 1

FIG 2